# EUROPEAN PATENT APPLICATION

(11) **EP 4 610 882 A1**
(43) Date of publication of application: **03.09.2025**
(21) Application number: 24160447.9
(22) Date of filing: 29.02.2024
(51) Int. Cl.: G06N 3/0455, G06N 3/0475, G06N 3/098

(54) **METHODS AND SYSTEMS FOR COLLECTING DATA SAMPLES FOR DEVELOPMENT OF AN AUTOMATED DRIVING SYSTEM OF A VEHICLE**

(71) Applicant: Zenseact AB, 417 56 Göteborg (SE)
(72) Inventor: LUVÖ, Thomas, 443 60 Stenkullen (SE); PETERSSON, Christoffer, 426 58 Västra Frölunda (SE)
(74) Representative: Zacco Sweden AB

(57) **Abstract**

A computer-implemented method (100) for collecting data samples for development of an automated driving system of a vehicle. The method (100) comprising: obtaining (5102) one or more sensor data embeddings of sensor data depicting a surrounding environment of the vehicle, wherein the one or more sensor data embeddings are representations of the sensor data in a multi-dimensional space and generated by processing the sensor data through one or more encoding networks that have been trained to process sensor data and to output a corresponding sensor data embedding for the sensor data in the multi-dimensional space; generating (S106) synthetic data from the one or more sensor data embeddings, wherein the synthetic data is associated with the sensor data represented by the one or more sensor data embeddings and generated by processing the sensor data embeddings through one or more decoding networks that has been trained to process sensor data embeddings and to output corresponding synthetic data for each sensor data embedding, and wherein each of the one or more decoding networks has been trained in association with at least one of the one or more encoding networks so as to relate to the same multi-dimensional space; and storing (S108) the generated synthetic data.

## Description

### TECHNICAL FIELD

The herein disclosed technology relates to the field of autonomous driving. In particular, but not exclusively, the herein disclosed technology relates to methods and systems for collecting data samples for development of an automated driving system of a vehicle

### BACKGROUND

Vehicles which are equipped with an advanced driver-assistance systems (ADASs) and/or autonomous driving (AD) systems, collectively referred to herein as Automated Driving Systems (ADSs), generate huge amounts of sensor-related data as they are driven around. Data from real-life scenarios is critical in a data-driven development organization where the ADS performance scales with amount of data collected. Current ADS solutions often rely upon data servers containing sensor data from a small amount of dedicated test vehicles collected in a limited time frame. These data collections therefore contain a very limited number of scenarios, and with ADS features continuously being developed and updated through Over-The-Air (OTA) updates, it is difficult to maintain adequate performance over time. Thus, it is envisioned that the next-generation of ADS solutions will be leveraged by continuously collecting data from the production fleet.

However, accessing the data from an entire fleet of vehicles (i.e. production vehicles or customer vehicles) and transmitting the data to a centralized server is very costly and technically challenging due to storage limitations, bandwidth limitations, and the immense need of post-processing to extract the relevant datasets for each individual use-case. Moreover, data privacy is a further concern, which can be subject to restrictions in certain countries, regulatory frameworks, and legislative areas. A problem can e.g. arise when the sensor data comprises sensitive information, and may forbid or limit upload and storage of such data. There is therefore a need for new and improved solutions for dealing with these aspects.

### SUMMARY

The herein disclosed technology seeks to mitigate, alleviate or eliminate one or more of the above-identified deficiencies and disadvantages in the prior art to address various problems relating to both technical constraints (bandwidth limitations, storage limitations, etc.) and data privacy considerations in the collection of data from a fleet of ADS equipped vehicles for evaluating and improving the performance of the ADS.

At the core of the solution is, as realized by the inventors, the availability of embeddings-generators for mapping collected sensor data into a representation in a latent space. This may unlock new functionalities which can aid in solving the above-mentioned problems. More specifically, the collected sensor data can be encoded into a compressed representation (that is the embedding) in the vehicle. After upload to a server (or other data collection center), the embeddings can be run through a decoding network to generate synthetic data that is representative of the original sensor data. The synthetic data may still comprise the general information needed for use e.g. in ADS development, while the more specific and sensitive information is suppressed (and in some sense lost) in the encoding-decoding process. Thereby the sensitive and data bandwidth problems can at least partly be overcome.

The embedding-to-synthetic-sensor-data generator can potentially solve an additional problem of low data quality. In cases where sensor data streams are missing from logged data, or comprising corrupt data, embeddings from the available data can be generated and missing or corrupt data streams can be complimented with the synthetic sensor data to create a complete data stream.

Various aspects and embodiments of the disclosed technology are defined below and in the accompanying independent and dependent claims.

According to a first aspect of the disclosed technology, there is provided a computer implemented method for collecting data samples for development of an automated driving system of a vehicle. The method comprises obtaining one or more sensor data embeddings of sensor data depicting a surrounding environment of the vehicle. The one or more sensor data embeddings are representations of the sensor data in a multi-dimensional space and generated by processing the sensor data through one or more encoding networks that have been trained to process sensor data and to output a corresponding sensor data embedding for the sensor data in the multi-dimensional space. The method further comprises generating synthetic data from the one or more sensor data embeddings. Herein, the synthetic data is associated with the sensor data represented by the one or more sensor data embeddings and generated by processing the sensor data embeddings through one or more decoding networks that has been trained to process sensor data embeddings and to output corresponding synthetic data for each sensor data embedding. Each of the one or more decoding networks has been trained in association with at least one of the one or more encoding networks so as to relate to the same multi-dimensional space. The method further comprises storing the generated synthetic data.

According to a second aspect of the disclosed technology, there is provided a computer program product comprising instructions which, when the program is executed by a computing device, causes the computing device to carry out the method according to any one of the embodiments of the first aspect disclosed herein. With this aspect of the disclosed technology, similar advantages and preferred features are present as in the other aspects.

According to a third aspect of the disclosed technology, there is provided a (non-transitory) computer-readable storage medium comprising instructions which, when executed by a computing device, causes the computing device to carry out the method according to any one of the embodiments of the first aspect disclosed herein. With this aspect of the disclosed technology, similar advantages and preferred features are present as in the other aspects.

The term "non-transitory," as used herein, is intended to describe a computer-readable storage medium (or "memory") excluding propagating electromagnetic signals, but are not intended to otherwise limit the type of physical computer-readable storage device that is encompassed by the phrase computer-readable medium or memory. For instance, the terms "non-transitory computer readable medium" or "tangible memory" are intended to encompass types of storage devices that do not necessarily store information permanently, including for example, random access memory (RAM). Program instructions and data stored on a tangible computer-accessible storage medium in non-transitory form may further be transmitted by transmission media or signals such as electrical, electromagnetic, or digital signals, which may be conveyed via a communication medium such as a network and/or a wireless link. Thus, the term "non-transitory", as used herein, is a limitation of the medium itself (i.e., tangible, not a signal) as opposed to a limitation on data storage persistency (e.g., RAM vs. ROM).

According to a fourth aspect of the disclosed technology, there is provided a server for collecting data samples for development of an automated driving system of a vehicle. The server comprises control circuitry configured to obtain one or more sensor data embeddings of sensor data depicting a surrounding environment of the vehicle. The one or more sensor data embeddings are representations of the sensor data in a multi-dimensional space and generated by processing the sensor data through one or more encoding networks that have been trained to process sensor data and to output a corresponding sensor data embedding for the sensor data in the multi-dimensional space. The control circuitry is further configured to generate synthetic data from the one or more sensor data embeddings. The synthetic data is associated with the sensor data represented by the one or more sensor data embeddings and generated by processing the sensor data embeddings through one or more decoding networks that has been trained to process sensor data embeddings and to output corresponding synthetic data for each sensor data embedding. Each of the one or more decoding networks has been trained in association with at least one of the one or more encoding networks so as to relate to the same multi-dimensional space. The control circuitry is further configured to store the generated synthetic data. With this aspect of the disclosed technology, similar advantages and preferred features are present as in the other aspects.

According to a fifth aspect, there is provided a method for managing event recordings in a system. The system comprises a fleet of vehicles equipped with an automated driving system, and a server communicatively connected to the fleet of vehicles. The method comprises obtaining, by a vehicle of the fleet of vehicles, sensor data depicting a surrounding environment of the vehicle and captured by one or more sensors of the vehicle. The method further comprises generating, by the vehicle, one or more sensor data embeddings of the sensor data. The one or more sensor data embeddings are representations of the sensor data in a multi-dimensional space and generated by processing the sensor data through one or more encoding networks that have been trained to process sensor data and to output a corresponding sensor data embedding for the sensor data in the multi-dimensional space. The method further comprises transmitting, by the vehicle, the one or more sensor data embeddings to the server. The method further comprises receiving, by the server, the one or more sensor data embeddings from the vehicle. The method further comprises generating, by the server, synthetic data from the one or more sensor data embeddings. The synthetic data is associated with the sensor data represented by the one or more sensor data embeddings and generated by processing the sensor data embeddings through one or more decoding networks that has been trained to process sensor data embeddings and to output corresponding synthetic data for each sensor data embedding. Each of the one or more decoding networks has been trained in association with at least one of the one or more encoding networks so as to relate to the same multi-dimensional space. The method further comprises storing, by the server, the generated synthetic data. With this aspect of the disclosed technology, similar advantages and preferred features are present as in the other aspects.

According to a sixth aspect, there is provided a system. The system comprises a fleet of vehicles equipped with an automated driving system. The system further comprises a server communicatively connected to the fleet of vehicles. A vehicle of the fleet of vehicles comprises control circuitry configured to obtain sensor data depicting a surrounding environment of the vehicle and captured by one or more sensors of the vehicle. The control circuitry of the vehicle is further configured to generate one or more sensor data embeddings of the sensor data. The one or more sensor data embeddings are representations of the sensor data in a multi-dimensional space and generated by processing the sensor data through one or more encoding networks that have been trained to process sensor data and to output a corresponding sensor data embedding for the sensor data in the multi-dimensional space. The control circuitry of the vehicle is further configured to transmit the one or more sensor data embeddings to the server. The server comprises control circuitry configured to receive the one or more sensor data embeddings from the vehicle. The control circuitry of the server is further configured to generate synthetic data from the one or more sensor data embeddings. The synthetic data is associated with the sensor data represented by the one or more sensor data embeddings and generated by processing the sensor data embeddings through one or more decoding networks that has been trained to process sensor data embeddings and to output corresponding synthetic data for each sensor data embedding. Each of the one or more decoding networks has been trained in association with at least one of the one or more encoding networks so as to relate to the same multi-dimensional space. The control circuitry of the server is further configured to store the generated synthetic data. With this aspect of the disclosed technology, similar advantages and preferred features are present as in the other aspects.

The disclosed aspects and preferred embodiments may be suitably combined with each other in any manner apparent to anyone of ordinary skill in the art, such that one or more features or embodiments disclosed in relation to one aspect may also be considered to be disclosed in relation to another aspect or embodiment of another aspect.

An advantage of some embodiments is that collection of data from ADS equipped vehicles is rendered more efficient and cost effective. It may further provide means for better identification and detection of relevant data to collect.

An advantage of some embodiments is that the data collection from ADS equipped vehicles is rendered more bandwidth-efficient, in terms of more compressed data being transmitted.

An advantage of some embodiments is that the data collection from ADS equipped vehicles is rendered more secure from a data privacy and integrity perspective, as the generation and subsequent use (in the ADS development) of synthetic data reduces the risk of sensitive data being collected and stored.

An advantage of some embodiments is that insight into the fleet of ADS equipped vehicles is enabled with efficient utilization of processing, memory and transmission resources.

An advantage of some embodiments is that one no longer has to rely on special-purpose test vehicles to gain insight into the workings of the ADS since data collection from a large vehicle fleet (i.e. production fleet) is rendered possible.

An advantage of some embodiments is that faster releases of more performant and safer ADS functions are possible as compared to prior known solutions.

An advantage of some embodiments is that it allows for generation of sensor data which are missing or for some reason not available after collection.

Further embodiments are defined in the dependent claims. It should be emphasized that the term "comprises/comprising" when used in this specification is taken to specify the presence of stated features, integers, steps, or components. It does not preclude the presence or addition of one or more other features, integers, steps, components, or groups thereof.

These and other features and advantages of the disclosed technology will in the following be further clarified with reference to the embodiments described hereinafter.

### BRIEF DESCRIPTION OF THE DRAWINGS

The above aspects, features and advantages of the disclosed technology, will be more fully appreciated by reference to the following illustrative and non-limiting detailed description of example embodiments of the present disclosure, when taken in conjunction with the accompanying drawings, in which:
Fig. 1 is a schematic flowchart representation of a method for collecting data samples for development of an automated driving system of a vehicle in accordance with some embodiments.
Fig. 2 is a schematic flowchart representation of a method for managing event recordings in a system in accordance with some embodiments.
Fig. 3 illustrates, by way of example, a system in accordance with some embodiments.
Fig. 4 is a schematic illustration of a server in accordance with some embodiments.
Fig. 5 is a schematic illustration of a vehicle in accordance with some embodiments.
Fig. 6 is a schematic block diagram representation of the system for managing event recordings in accordance with some embodiments.

### DETAILED DESCRIPTION

The present disclosure will now be described in detail with reference to the accompanying drawings, in which some example embodiments of the disclosed technology are shown. The disclosed technology may, however, be embodied in other forms and should not be construed as limited to the disclosed example embodiments. The disclosed example embodiments are provided to fully convey the scope of the disclosed technology to the skilled person. Those skilled in the art will appreciate that the steps, services and functions explained herein may be implemented using individual hardware circuitry, using software functioning in conjunction with a programmed microprocessor or general-purpose computer, using one or more Application Specific Integrated Circuits (ASICs), using one or more Field Programmable Gate Arrays (FPGA) and/or using one or more Digital Signal Processors (DSPs).

It will also be appreciated that when the present disclosure is described in terms of a method, it may also be embodied in apparatus comprising one or more processors, one or more memories coupled to the one or more processors, where computer code is loaded to implement the method. For example, the one or more memories may store one or more computer programs that causes the apparatus to perform the steps, services and functions disclosed herein when executed by the one or more processors in some embodiments.

It is also to be understood that the terminology used herein is for purpose of describing particular embodiments only, and is not intended to be limiting. It should be noted that, as used in the specification and the appended claim, the articles "a", "an", "the", and "said" are intended to mean that there are one or more of the elements unless the context clearly dictates otherwise. Thus, for example, reference to "a unit" or "the unit" may refer to more than one unit in some contexts, and the like. Furthermore, the words "comprising", "including", "containing" do not exclude other elements or steps. It should be emphasized that the term "comprises/comprising" when used in this specification is taken to specify the presence of stated features, integers, steps, or components. It does not preclude the presence or addition of one or more other features, integers, steps, components, or groups thereof. The term "and/or" is to be interpreted as meaning "both" as well and each as an alternative.

It will also be understood that, although the term first, second, etc. may be used herein to describe various elements or features, these elements should not be limited by these terms. These terms are only used to distinguish one element from another. For example, a first element could be termed a second element, and, similarly, a second element could be termed a first element, without departing from the scope of the embodiments. The first element and the second element are both elements, but they are not the same element.

### Overview

An imperative aspect of achieving reliable Automated Driving System (ADS) functionality for the vehicles of tomorrow is to obtain a comprehensive understanding of the scenarios occurring in the surrounding environment of the vehicle, as well as understanding how the vehicle (or its ADS) tackles the scenario. The unpredictable and dynamic scenarios including situations, events or objects in the surrounding environment of the vehicle and on the roads on which the vehicle is travelling can involve nearly endless varieties and complexities. In other words, there is a need for immense amounts of data (sensor data logged by vehicles) for achieving reliable autonomous functionality.

However, some of the challenges with collecting data from a fleet of vehicles for the purpose of testing, developing, and verifying ADS functions is that simply transmitting all of the data is unfeasible due to the immense need of bandwidth and transmission resources, and also due to the insurmountable post-processing task required to extract relevant data samples. A further aspect of this data collection is data privacy. Some sensor data can for instance comprise rich information about the environment, including details about other vehicles, pedestrians, and infrastructure. It can therefore comprise sensitive data which are subject to different regulatory frameworks or legislations in different countries, and which may need to be anonymized. One also needs to ensure that the data is protected transmitted and stored, e.g. through signal encryption.

Overall, addressing cost and data privacy concerns in autonomous vehicles requires a comprehensive approach that considers the ethical, legal, and technical aspects of data collection, storage, and usage. Implementing privacy-preserving technologies and adhering to strict regulatory frameworks, is therefore of great importance.

Thus, it is desirable to enable a data collection and manage event recordings through privacy-preserving technologies which at the same time offers effective data collection, transmission, and storage, as well as providing added value to the collected data. In providing innovative mobility solutions, all this is aimed at ensuring that autonomous vehicles respect individuals' privacy rights. Various aspects and embodiments disclosed herein aim to provide a solution to easily, and securely, collect data samples for use in development of the ADS. To this end, the herein disclosed technology proposes the use of embeddings, which is a technique to express information as vectors, in something one can call a data space, vector space or latent space, and to then recreate the original data through the generation of synthetic data.

In short, it is herein proposed to utilize encoding networks (artificial neural networks trained to generate a representation of the input in the data space), or embedding networks, on the vehicle's sensor data (sensor output), and optionally on other data as well, and to utilize decoding networks (artificial neural networks trained to generate synthetic data from said representation of the original data in the data space) to recreate the encoded data. The encoding networks and decoding networks are herein proposed to be trained together (i.e. jointly in a loop) such that the encoding networks learn to generate the representations of the input data, and the decoding networks learn to recreate the input data from the generated representations.

By deploying the encoding networks and decoding networks in separate entities (e.g. the encoding networks in a vehicle, and the decoding network in a server), a privacy layer can be introduced therebetween. By first encoding, and then decoding the sensor data, any sensitive information in the original data may be lost (or masked) in the resulting synthetic data. However, the more general information in the original data may be maintained, so as to allow the synthetic sensor data to be used in the further development of the ADS, e.g. as training data for another machine learning model, simulations, gaining insight etc. Additionally, the transmission of data between the separate entities can be done in the form of the encoded representations (or embeddings), which saves space since they form a more compressed data representation, and improves security. The latter because the encoded representation, if intercepted by a third party, will make little to no sense unless the correct decoding network is available to recreate the original data. Further aspects of the disclosed technology will become apparent from the detailed description below.

### Definitions

In the present context, an "Automated Driving System" ("ADS") refers to a complex combination of hardware and software components designed to control and operate a vehicle without direct human intervention. ADS technology aims to automate various aspects of driving, such as steering, acceleration, deceleration, and monitoring of the surrounding environment. The primary goal of an ADS is to enhance safety, efficiency, and convenience in transportation. An ADS can range from basic driver assistance systems to highly advanced autonomous driving systems, depending on its level of automation, as classified by standards like the SAE J3016. These systems use a variety of sensors, cameras, radar, lidar, and powerful computer algorithms to perceive the environment and make driving decisions. The specific capabilities and features/functions of an ADS can vary widely, from systems that provide limited assistance to those that can handle complex driving tasks independently in specific conditions.

Advanced Driver Assistance Systems (ADAS) are technologies that assist drivers in the driving process, though they do not necessarily offer full autonomy. ADAS features often serve as building blocks for ADS. Examples include adaptive cruise control, lane-keeping assist, automatic emergency braking, and parking assistance. They enhance safety and convenience but typically require some level of human supervision and intervention. On the other hand, Autonomous Driving (AD) are technologies that are designed to control and navigate a vehicle without human supervision. Accordingly, it can be said that the distinction between ADAS and AD lies in the level of autonomy and control. ADAS systems are designed to aid and support drivers, while an AD aims to take full control of the vehicle without requiring constant human oversight. AD accordingly aims for higher levels of autonomy (such as Levels 4 and 5, according to the SAE International standard), where the vehicle can operate independently in most or all driving scenarios without human intervention. As mentioned in the foregoing, the term "ADS" in used herein as an umbrella term encompassing both ADAS and AD. An ADS function or ADS feature may in the present context be understood as a specific function or feature of the entire ADS stack, such as e.g., a Highway Pilot feature, a Traffic-Jam pilot feature, a path planning feature, and so forth.

The term "perception data" refers to the information gathered by sensors and other technologies that are used by ADS-equipped vehicles to detect and interpret their environment. This includes data collected from cameras, lidar, radar, and other sensors that help the vehicle "perceive" its surroundings and make decisions based on that information. The perception data collected by the vehicle may include the position, speed, and direction of nearby objects, position and type of road markings, position and type of traffic signs, and other relevant information. This data may then be processed by the vehicle's onboard computer to help it make decisions on steering, acceleration, braking, and other actions necessary to safely navigate the environment. Accordingly, the term "perception" data may refer to "surroundings assessment" data, "spatial perception" data, "processed sensory" data and/or "temporal dependencies" data, whereas perception "data" may refer to perception "information" and/or "estimates". The term "obtained" from a perception module or perception system, on the other hand, may refer to "derived" from a perception model and/or "based on output data" from a perception module or system. Whereas perception module/system configured to "generate the set of perception data" may refer to perception module/system adapted and/or configured to "estimate the surroundings of said vehicle", "estimate at least a portion of surroundings of said vehicle", "determine surroundings of said vehicle", "interpret sensory information relevant for the autonomous maneuvering of said vehicle", and/or "estimate surroundings of said vehicle and make model predictions of future states of the surroundings of said vehicle".

In the present context, a "sensor" or "sensor device" refers to a specialized component or system that is designed to capture and gather information from the vehicle's surroundings. It may further refer to components for gathering information of the vehicle itself. These sensors play a crucial role in enabling the ADS to perceive and understand their environment, make informed decisions, and navigate safely. Sensors are typically integrated into the autonomous vehicle's hardware and software systems to provide real-time data for various tasks such as obstacle detection, localization, road model estimation, and object recognition. Common types of sensors used in autonomous driving include LiDAR (Light Detection and Ranging), Radar, Cameras, Ultrasonic sensors, inertial measurement unit (IMU), GPS, wheel speed sensors etc. LiDAR sensors use laser beams to measure distances and create high-resolution 3D maps of the vehicle's surroundings. Radar sensors use radio waves to determine the distance and relative speed of objects around the vehicle. Camera sensors capture visual data, allowing the vehicle's computer system to recognize traffic signs, lane markings, pedestrians, and other vehicles. Ultrasonic sensors use sound waves to measure proximity to objects. Various machine learning algorithms (such as e.g., artificial neural networks) may be employed to process the output from the sensors to make sense of the environment.

A driver monitoring system (DMS) can be understood as a system comprising one or more cameras focused on a driver of the vehicle in order to capture images of the driver's face so to determine various facial characteristics of the driver including the position, orientation, and movement of the driver's eyes, face and head. Moreover, the DMS may be further configured to derive a state of the driver based on the determined facial characteristics, such as e.g., if the driver is in an attentive or inattentive state, if the driver is tired, if the driver is drowsy, and so forth.

In the present context, the term "data sample" refers to a subset of data taken from a larger dataset or data stream. In particular, the "data samples" may be collected by sampling data output by a sensor of the vehicle or other sources (e.g., outputs from various functions of the ADS). The data may be sampled with a suitable sample rate given the size of dataset. For example, the data may be sampled with 0,1 second intervals, 0,5 second intervals, 1 second intervals, or the like. In some examples, the data samples include "sensor data samples". The data sample may be used for development of the ADS. For example, a data sample may be annotated, and used in training of a machine learning model used as part of the ADS.

The data sample may be a sample of sensor data, also referred to as a "sensor data sample". The sensor data sample may be interpreted as a specific instance or set of data collected by the sensors installed on the ADS-equipped vehicles at a particular moment in time or within a specific timeframe. The sensor data samples typically comprise various types of information captured by the sensors, such as camera images, lidar output, radar output, GPS coordinates, accelerometer readings, and other sensor-generated data. The "sensor data samples" may include connected meta data (e.g., timestamps, location information, vehicle information, log duration, etc.). A data sample of sensor data (or sensor data sample) may e.g. correspond to an image frame from a camera, or a lidar point-cloud for a certain point in time.

The term encoding network (more specifically referred to as "embedding network", "embedding neural network", or "embedding artificial neural network") refers to a computational model or set of techniques that are used to enable a computer to generate an embedding for an input data sample (e.g. sensor data or sensor data sample), where an "embedding" may be understood as a mathematical representation of said input data. In more detail, the "encoding network" is used to transform high-dimensional data into a lower-dimensional space (multi-dimensional (vector) space) while preserving meaningful relationships between the input data points.

Embedding networks are for example used for tasks like natural language processing (NLP) and computer vision. These networks take raw input data, such as words in a sentence or pixels in an image, and convert them into fixed-size, numerical vectors (embeddings) that capture essential characteristics or features of the input data. In more detail, in NLP, the embedding networks convert words into numerical vectors, where words with similar meanings or contextual usage are represented closer to each other in the embedding space (or multi-dimensional space). Similarly, in computer vision, the embedding networks convert images to numerical vectors, enabling the network to understand visual similarities, like grouping similar objects or scenes closer together in the embedding space (multi-dimensional (vector) space).

Neural networks or artificial neural networks, emulate computing systems inspired by biological neural networks found in the brains of living creatures. These systems exhibit learning capabilities, progressively enhancing their performance without requiring task-specific programming. For instance, in image recognition, a neural network can be trained to detect specific objects within images by analysing labelled example images. Once it grasps the correlation between objects and their names, it can apply this knowledge to identify similar objects in unlabeled images.

Fundamentally, a neural network consists of interconnected units known as neurons, connected by synapses that transmit signals of varying strengths. These signals travel unidirectionally, activating receiving neurons based on the strength of these connections. The combined incoming signals, originating from multiple transmitting neurons can then be fed to a receiving neuron which activates and transmits a signal to downstream neurons. This activation strength becomes a crucial parameter governing signal propagation within the network. Different activation functions can be used, such as continuous activation function (e.g. sigmoid), or partially continuous activation functions (e.g. ReLU).

Moreover, during the training of a neural network architecture, regression-comprised of statistical processes for understanding variable relationships-can involve minimizing a cost function. This function gauges the network's performance in accurately linking training examples to their intended outputs. A technique called backpropagation can then be employed. Backpropagation, a widely used method for training artificial neural networks, collaborates with optimization methods like stochastic gradient descent (SGD).

Moreover, use of backpropagation can include propagation and weight update. Backpropagation involves two key steps: propagation and weight adjustment. When an input enters the neural network, it moves forward through each layer until it reaches the output layer. Here, the neural network's output is measured against the desired output using a cost function, generating an error value for each output node. These errors then flow backward, starting from the output layer, assigning error values to each node based on its contribution to the final output. These error values are pivotal-they aid in computing the cost function's gradient concerning the neural network's weights. This gradient guides the selected optimization technique, adjusting the weights to minimize the cost function.

Accordingly, the encoding network itself may comprise layers of neural network architecture, often employing techniques like convolutional layers, recurrent layers, fully connected layers, attention layers, or transformer layers, to learn and extract meaningful patterns from the input data. The encoding networks may be trained through processes like supervised learning, unsupervised learning, or self-supervised learning to optimize the embeddings for specific downstream tasks, such as classification, clustering, or recommendation.

In some embodiments, the various encoding networks are trained to generate embeddings in the same embedding space (the same multi-dimensional space or the same multi-dimensional vector space) so that embeddings (generated by different encoding networks) that are contextually, spatially and/or temporally related point towards the same point within the multi-dimensional space. The term "point towards the same point within the multi-dimensional space" should in the present context be interpreted broadly, and encompass "point in substantially the same direction within the multi-dimensional space" or "point towards substantially the same point within the multi-dimensional space" and so forth. In more detail, having two embedding vectors pointing towards the same point or in the same direction, one can infer a relationship between the two underlying data samples. For example, if one has two embedding vectors, one can calculate how close they are to pointing towards the same point or how close they are to pointing in the same direction in order to determine a relationship between the underlying data samples, where the closer they are to pointing towards the same point or the same direction, the more likely it is that the underlying data samples relate to the same object or scene.

This may for example be done by training a first encoding network, to generate embeddings in a multi-dimensional space, based on input data from a first data source. Then, each of the other encoding networks are trained "against" or in association with the first encoding network so that the embeddings of the other networks that are contextually, spatially and/or temporally related with the embeddings of the first encoding network point towards the same point within the multi-dimensional space as the related embeddings of the first encoding network. For example, if the first encoding network is trained to generate image embeddings for camera images and a second encoding network is intended to generate embeddings for Lidar data, then the second encoding network may be trained by feeding the second encoding network with lidar data of a scene where corresponding image embeddings (of that scene) will be used as basis for forming a ground-truth (desired output). By doing this process for each subsequent encoding network, one may obtain a set of encoding networks capable of ingesting outputs from various data sources and output corresponding embeddings where contextual, spatial and/or temporal relations are represented by the proximity or similarly in direction of the embeddings (vectors) in the multi-dimensional space.

For the decoding networks, the same principles and aspects apply, as for the encoding networks. A difference being that the decoding networks are trained to generate synthetic data from embeddings, such as those outputted from the encoding networks, as opposed to the other way around. By the wording "synthetic", as in synthetic data, is herein meant synthetic in the sense that it is machine generated (herein by the decoding networks), as opposed to being recorded or otherwise collected data of the real world. The synthetic data may also be referred to as pseudo data. The synthetic data can be understood as a different version of the original data.

There are several possible architectures for the decoding network. For example, the decoder-part of AutoEncoders or Variational AutoEncoders, the generator-part of (conditional) Generative Adversarial Networks, and Diffusion Models in which the embedding vector guides the diffusion process of generating an image that closely aligns with the information contained in the embedding vector.

An encoding network and a decoding network may be trained in association with each other, e.g. by being trained together in a loop. Thus, they are trained so as to relate to the same multi-dimensional space. This training process may be referred to as network fusion. The training process may involve feeding a data sample (e.g. an image) through the encoding network to generate an embedding for the data sample. This embedding is then fed through the decoding network which outputs a reconstruction of the original data sample inputted to the encoding network.

### Embodiments

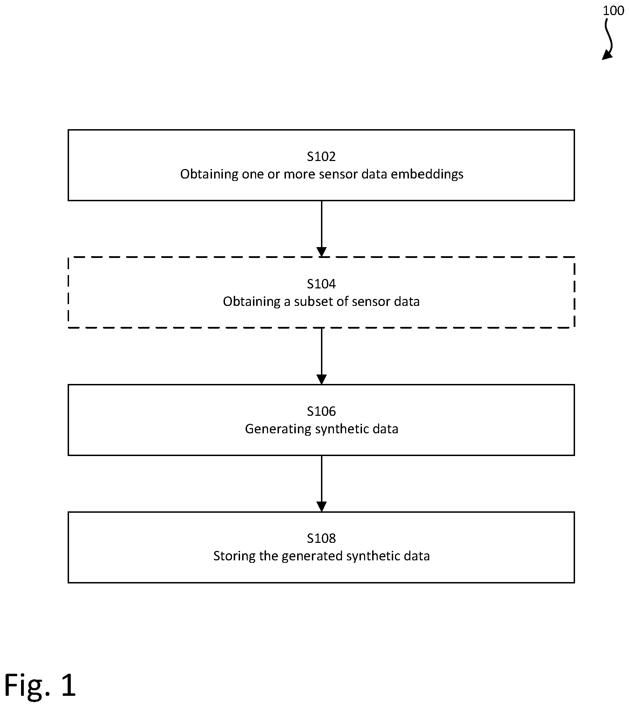

Figure 1 is a schematic flowchart representation of a method 100 in accordance with some embodiments. More specifically, the method 100 may be a method 100 for collecting data samples for development of an automated driving system of a vehicle. The method S100 is preferably a computer-implemented method 100, performed by a processing system of a server (may also be referred to as remote server, cloud server, central server, back-office server, fleet server, or back-end server). The processing system may for example comprise one or more processors and one or more memories coupled to the one or more processors, wherein the one or more memories store one or more programs that perform the steps, services and functions of the method S100 disclosed herein when executed by the one or more processors.

Below, the different steps of the method 100 are described in more detail. Even though illustrated in a specific order, the steps of the method 100 may be performed in any suitable order as well as multiple times. Thus, although Fig. 1 may show a specific order of method steps, the order of the steps may differ from what is depicted. In addition, two or more steps may be performed concurrently or with partial concurrence. For example, the steps denoted S102 and S104 may be performed in any order or at any point in time, based on a specific realization. Such variation will depend on the software and hardware systems chosen and on designer choice. All such variations are within the scope of the invention. Likewise, software implementations could be accomplished with standard programming techniques with rule-based logic and other logic to accomplish the various steps. Further variants of the method 100 will become apparent from the present disclosure. The herein described embodiments are only given as examples and should not be limiting to the present invention. Other solutions, uses, objectives, and functions within the scope of the invention as claimed below described patent claims should be apparent for the person skilled in the art. It should be appreciated that the steps which are comprised in dashed lines in Fig. 1 are examples of a number of optional steps which may form part of a number of alternative embodiments. The optional steps need not be performed in order. Furthermore, it should be appreciated that not all of the optional steps need to be performed.

The method 100 comprises obtaining S102 one or more sensor data embeddings of sensor data depicting a surrounding environment of a vehicle. The one or more sensor data embeddings may e.g. be obtained by being received from the vehicle, or retrieved from a data buffer or storage medium located in the server. The one or more sensor data embeddings may be obtained in response to certain triggering events, as will be further explained below.

In general, the term "obtaining" as used herein, is to be interpreted broadly and encompasses receiving, retrieving, collecting, acquiring, and so forth directly and/or indirectly between two entities or components configured to be in communication with each other or further with other external entities. However, in some embodiments, the term "obtaining" is to be construed as determining, deriving, forming, computing, etc.

As previously described, the one or more sensor data embeddings are representations of the sensor data in a multi-dimensional space. Moreover, the one or more sensor data embeddings are generated by processing the sensor data through one or more encoding networks that have been trained to process sensor data and to output a corresponding sensor data embedding for the sensor data in the multi-dimensional space. The sensor data embeddings are thus to be seen as embeddings generated for sensor data.

The sensor data may comprise various types of information captured by one or more sensors of the vehicle, such as camera images, lidar output, radar output, GPS coordinates, accelerometer readings, and other sensor-generated data. The sensor data may comprise both data depicting the surrounding environment and associated meta data. The surrounding environment of a vehicle is herein to be understood as a general area around the vehicle in which objects (such as other vehicles, landmarks, obstacles, etc.) can be detected and identified by vehicle sensors (RADAR, LIDAR, cameras, etc.), i.e. within a sensor range of the vehicle. Thus, the sensor data may give information about the position of other vehicles, pedestrians, obstacles, road conditions, and more. It may further give information about the direction of the lane or road in which the vehicle is travelling. It is to be appreciated that the principles of the present technology can also be applied to sensor data depicting an interior of the vehicle. E.g. as part of a driver monitoring system. The meta data may e.g. comprise timestamps, location information, vehicle information, log duration, etc.

The sensor data represented by the one or more sensor data embeddings may comprise data of one or more sensor data types (or data from sensors of one or more sensor types. The sensor data types may include, but are not limited to image data, lidar data, radar data, ultrasonic data, etc. A sensor data type may also encompass sensor data from different instances of the same sensor type. For example, one sensor data type may be image data from a first camera having a first field of view, while a second sensor data type may be image data from a second camera having a second field of view.

In some embodiments, each sensor data embedding of the one or more sensor data embeddings corresponds to a respective sensor data type of the one or more sensor data types. Thus, the one or more sensor data embeddings may be representative of sensor data of equally many sensor data types. As a non-limiting example, the one or more sensor data embeddings may comprise a first sensor data embedding generated for image data captured by a camera, and a second sensor data embedding generated for lidar data captured by a LIDAR sensor. It is to be appreciated that any number of sensor data embeddings may be obtained, as well as for any combination of sensor data types.

The one or more encoding networks may comprise a plurality of encoding networks of which each encoding network represent a respective/corresponding sensor data type of the one or more senor data types. In other words, in some embodiments, the sensor data represented by the one or more sensor data embeddings comprise sensor data output by two or more different sensors of the vehicle, and accordingly two or more corresponding encoding networks in a one-to-one ratio (i.e., each encoding network is related to one specific sensor (e.g. first camera, second camera, lidar sensor, radar, etc.) of the vehicle). Moreover, the plurality of encoding networks may comprise a first encoding network trained to process sensor data of a first sensor data type and to output a corresponding sensor data embedding (for each sensor data sample of the first sensor data type), and a second encoding network trained to process a second sensor data type and to output a corresponding sensor data embedding. The first and second sensor data types being different sensor data types. The first encoding network having been trained in association with the second encoding network such that a sensor data embedding generated by the first encoding network and a sensor data embedding generated by the second encoding network point towards the same point within the multi-dimensional space when the sensor data embeddings are contextually, spatially and/or temporally related. In some embodiments, each of the other encoding networks (i.e., the second encoding network for a second sensor data type (or a second sensor), a third encoding network for a third sensor data type (or a third sensor), etc.) has been trained in association with the first encoding network such that a sensor data embedding generated by the first encoding network and a sensor data embedding generated by each of the other encoding networks point towards the same point within the multi-dimensional space when the two-sensor data embeddings are contextually, spatially and/or temporally related.

Thus, in some embodiments, each encoding network may be configured to generate sensor data embeddings for a respective sensor data type. It is to be appreciated that the plurality of encoding networks may comprise any number of encoding networks, depending on a specific implementation. Thus, the plurality of encoding networks may further comprise a third encoding network, a fourth encoding network, etc. The plurality of encoding networks may all be trained together, in association with each other. Alternatively, the second encoding network, the third encoding network, and the fourth encoding network (and so on), may all be trained in association with the first encoding network. In another example, the second encoding network may be trained in association with the first encoding network, as stated above. The third encoding network may in turn be trained in association with the second encoding network. And the fourth encoding network may be trained in association with the third encoding network, and so forth.

Alternatively, or in combination, the one or more encoding networks may comprise a fused encoding network trained to process fused sensor data. The fused sensor data comprising at least two sensor data types of the one or more sensor data types. In other words, the fused encoding network may be trained to process at least two sensor data types, and output a sensor data embedding for each of the at least two sensor data types. The fused sensor data may comprise the at least two sensor data types individually, or processed to form a fused or combined sensor data type. In the latter case, a sensor data embedding representative of the combined sensor data type may be output, rather than one for each sensor data type respectively.

The method 100 further comprises generating S106 synthetic data from the one or more sensor data embeddings. The synthetic data is associated with the sensor data represented by the one or more sensor data embeddings. In other words, the synthetic data may in some way correspond to or represent the original sensor data for which the one or more sensor data embeddings was generated. The synthetic data may thus be seen as a reconstruction of the original sensor data, or any other data generated based on the original sensor data. Examples of what the synthetic data may comprise will be given below. The wording "original sensor data" as used herein may be construed as the sensor data for which the obtained one or more sensor data embeddings were generated.

As previously explained, the synthetic data is generated by processing the one or more sensor data embeddings through one or more decoding networks that has been trained to process sensor data embeddings and to output corresponding synthetic data for each sensor data embedding. Each of the one or more decoding networks has been trained in association with at least one of the one or more encoding networks so as to relate to the same multi-dimensional space. In addition, the one or more decoding networks may be trained in association with each other.

More specifically, for every encoding network used for generating the one or more sensor data embeddings, a corresponding decoding network may be used. By having the one or more encoding networks and the one or more decoding networks all being related to the same multi-dimensional space, allows for any decoding network to be used for generating the synthetic data, regardless of what encoding network has generated the sensor data embedding. As an example, the obtained one or more sensor data embeddings may be representative of sensor data in the form of image data, and thus generated by an encoding network trained to generate sensor data embeddings for image data. However, the sensor data embedding may be processed by a decoding network trained to generate synthetic LIDAR data, to thereby generate synthetic LIDAR data. However, the generated synthetic data may as well be of the same sensor data type as the original sensor data represented by the sensor data embedding.

The aspects and principles mentioned above for the one or more encoding networks are applicable also to the one or more decoding networks, unless otherwise stated. More specifically, the one or more decoding networks may comprise a plurality of decoding networks of which each decoding network represent a respective/corresponding sensor data type of the one or more senor data types. In other words, in some embodiments, the sensor data represented by the one or more sensor data embeddings comprise sensor data output by two or more different sensors of the vehicle, and accordingly two or more corresponding decoding networks in a one-to-one ratio (i.e., each decoding network is related to one specific sensor of the vehicle) can be used. Moreover, the plurality of decoding networks may comprise a first decoding network trained to process sensor data embeddings of a first sensor data type and to output corresponding synthetic (sensor or any other) data (for each sensor data embedding), and a second decoding network trained to process sensor data embeddings of a second sensor data type and to output corresponding synthetic data. The first and second sensor data types being different sensor data types. The first decoding network having been trained in association with the second decoding network such that they relate to the same multi-dimensional space. In some embodiments, each of the other decoding networks (i.e., the second decoding network for a second sensor data type (or a second sensor), a third decoding network for a third sensor data type (or a third sensor), etc.) has been trained in association with the first decoding network.

In some embodiments, each decoding network may be configured to generate synthetic sensor data for a respective sensor data type. It is to be appreciated that the plurality of decoding networks may comprise any number of decoding networks, depending on a specific implementation. Thus, the plurality of decoding networks may further comprise a third decoding network, a fourth decoding network, etc.

The plurality of decoding networks may all be trained together, in association with each other. Alternatively, the second decoding network, the third decoding network, and the fourth decoding network (and so on), may all be trained in association with the first decoding network. In another example, the second decoding network may be trained in association with the first decoding network, as stated above. The third decoding network may in turn be trained in association with the second decoding network. And the fourth decoding network may be trained in association with the third decoding network, and so forth. The plurality of decoding networks may however still be trained in association with at least one of the encoding networks. In some embodiments, an encoding and decoding network pair may be trained in relation to each other, and irrespective of the other encoding and decoding networks.

In some embodiments, the one or more decoding networks may comprise a fused decoding network trained to generate fused synthetic sensor data. The fused synthetic sensor data comprising a fusion of at least two sensor data types of the one or more sensor data types.

In some embodiments, the synthetic data comprises synthetic sensor data. In other words, the synthetic data may correspond to any sensor data type as described above. Alternatively, or in combination, the synthetic data may comprise synthetic text data. Thus, the synthetic data may comprise a textual description of the sensor data represented by the obtained one or more sensor data embeddings. The textual description may e.g. be a scenario description, i.e. a description of what happens in a scene depicted by the original sensor data (e.g. image/video captioning), or of any decisions (and reasons thereof) taken by the ADS of the vehicle. The textual description may e.g. be generated by use of any suitable machine learning technique, such as transformer models, Generative Adversarial Networks, etc. The synthetic data may further comprise (either as an alternative to, or in combination with the above) synthetic meta data associated with the original sensor data. It is to be appreciated that the generated synthetic data may comprise a mix of synthetic sensor data, synthetic text data, and synthetic meta data.

In some embodiments, the synthetic sensor data comprises synthetic sensor data of at least one sensor data type in common with the one or more sensor data types of the sensor data represented by the obtained one or more sensor data embeddings. In other words, the disclosed technology can be used to generate synthetic sensor data of a same type as the original sensor data, or to recreate synthetic data representing at least one of the original sensor data types. Thus, the synthetic sensor data may form a reconstruction of the original sensor data. Associated with this aspect is the advantages of reduced transmission cost, since it allows for sending the sensor data from a vehicle to the server in the form of sensor data embeddings having a reduces size compared to raw sensor data. Moreover, it provides for the advantages relating to the data privacy aspects as well.

In some embodiments, the synthetic sensor data comprises synthetic sensor data of at least one sensor data type other than the one or more sensor data types of the sensor data represented by the obtained one or more sensor data embeddings. In other words, the disclosed technology can be used to generate synthetic sensor data of a sensor data type that is not part of the original sensor data. In addition to the advantages described in the previous paragraph, this may further have the effect of making it possible to replace parts of the sensor data that are missing, having been corrupted, or in any other way being rendered less useful.

In some embodiments, the sensor data represented by the one or more sensor data embeddings depicts the surrounding environment of the vehicle at a first point in time. The synthetic data may then pertain to the surrounding environment of the vehicle at a second point in time. In other words, the synthetic data may pertain to the surrounding environment at the second point in time in the sense that it represents the surrounding environment of the vehicle as if it would have been captured at the second point in time. This may provide for generating synthetic sensor data depicting the surrounding environment at points in time different from those represented by the one or more sensor data embeddings. It is to be appreciated that sensor data embeddings for more than just the first point in time may be used as well.

As an example, synthetic sensor data pertaining to the surrounding environment at a point in time t can be generated based on sensor data embeddings representing sensor data depicting the surrounding environment at a point in time t-2 and t-1, by predicting the subsequent point in time. In another example, the synthetic sensor data at the point in time t can be generated based on sensor data embeddings for a point in time t-1 and a point in time t+1, by interpolation between the sensor data embeddings of both points in time.

The method 100 may further comprise obtaining S104 a subset of the sensor data represented by the one or more sensor data embeddings. Then, generating S106 the synthetic sensor data may be further based on the obtained subset of the sensor data. The obtained subset of the sensor data represented by the one or more sensor data embedding may comprise data of at least one sensor data type of the one or more sensor data types. Thus, part of the original sensor data may be used as further input when generating the synthetic sensor data. This may be to further improve the generation of the synthetic sensor data. To still maintain a desirable data privacy level, the obtained subset of sensor data may be of a less sensitive sensor data type (e.g. lidar data or radar data), which mainly comprises depth information. This data may then be used to e.g. generate synthetic sensor data of a sensor data type of higher sensitivity, such as image data, which naturally comprises more sensitive information (than lidar and radar data).

The method 100 further comprises storing S108 the generated synthetic data. The stored synthetic data may be used as data samples for further development of the automated driving system. For example, the synthetic data may be annotated and used in training of different ADS functions such as perception functions (e.g., object detection, object classification, semantic segmentation, free-space estimation, object tracking, etc.), path planning functions (e.g., candidate paths, executed paths, etc.), trajectory planning functions (e.g., candidate trajectories, executed trajectories, etc.), road model generation functions, localization functions, safety function output (e.g., Minimum Risk Manoeuvre (MRM) execution, collision avoidance execution, etc.) and so forth. Alternatively, or in combination, the synthetic sensor data may give insight into different scenarios or scenes experienced by the vehicle having captured the original sensor data, but with reduced data sensitivity.

Storing S108 the generated synthetic data may further comprise storing the one or more sensor data embeddings corresponding to the generated synthetic data.

Executable instructions for performing these functions are, optionally, included in a non-transitory computer-readable storage medium or other computer program product configured for execution by one or more processors.

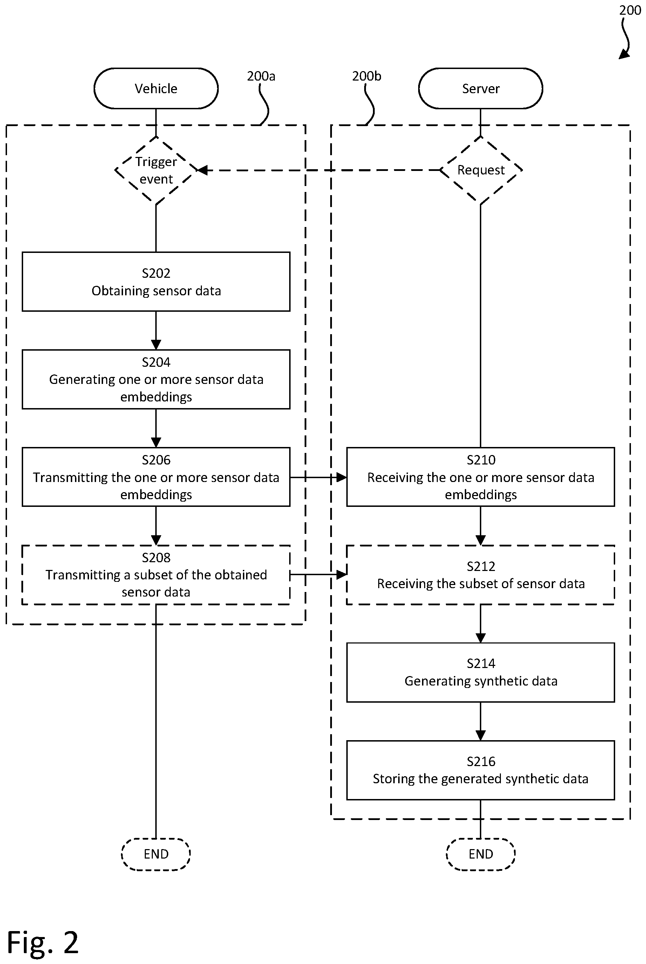

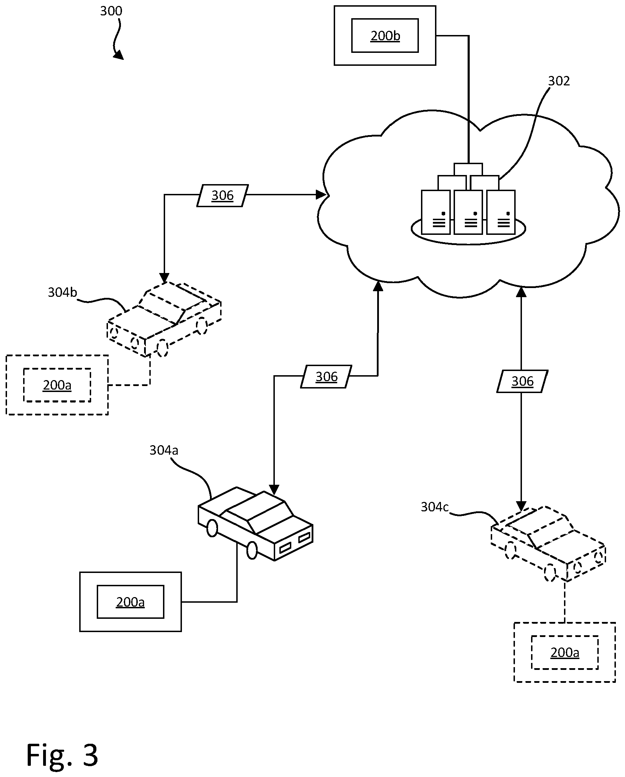

Figure 2 is a schematic flowchart representation of a method 200 in accordance with some embodiments. More specifically, the method 100 may be a method 100 for managing event recordings (or for collecting data samples for ADS-development) in a system 300. The system comprises a fleet of vehicles equipped with an automated driving system, and a server communicatively connected to the fleet of vehicles. Such a system will be further explained in connection with Fig. 3 below. The illustration in Fig. 2 shows, by way of example, how the different steps of the method 200 can be divided between a vehicle of the fleet, and the server. Thus, the method 200 can be seen as two sub-methods, namely a vehicle-end method 200a, and a server-end method 200b. However, it goes without saying that some of the steps may be performed either by the vehicle, by the server, or jointly by the vehicle and the server, depending on a specific realization. First, the vehicle-end method 200a will be described, followed by the server-end of the method 200b. As is readily realized, any principles or aspects of the method 100 described above in connection with Fig. 1, apply also to the method 200 described in connection with Fig. 2.

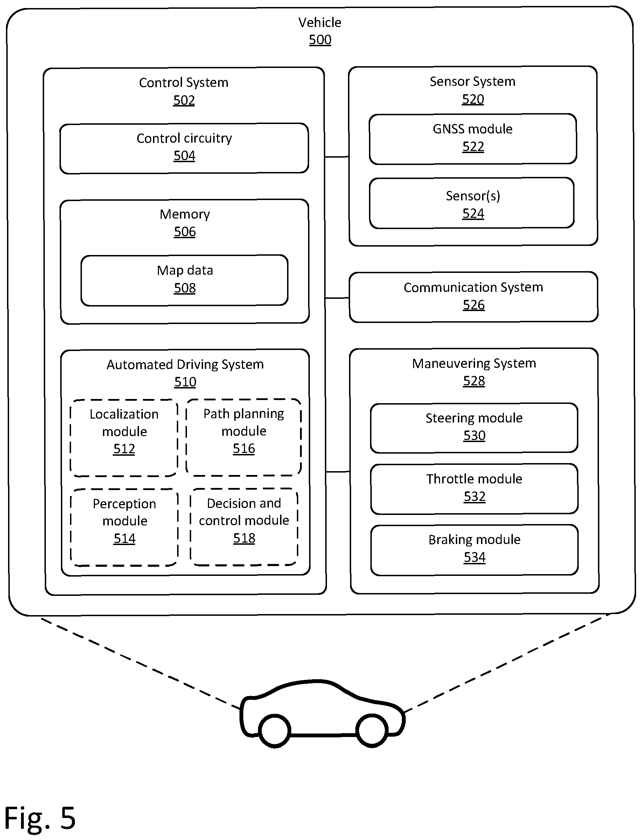

Below, the different steps of the method 200 are described in more detail. Even though illustrated in a specific order, the steps of the method 200 may be performed in any suitable order as well as multiple times. Thus, although Fig. 2 may show a specific order of method steps, the order of the steps may differ from what is depicted. In addition, two or more steps may be performed concurrently or with partial concurrence. For example, the steps denoted S206 and S208 may be performed in any order or at any point in time, based on a specific realization. The same goes for the steps denoted S210 and S212. Such variation will depend on the software and hardware systems chosen and on designer choice. All such variations are within the scope of the invention. Likewise, software implementations could be accomplished with standard programming techniques with rule-based logic and other logic to accomplish the various steps. Further variants of the method 200 will become apparent from the present disclosure. The herein described embodiments are only given as examples and should not be limiting to the present invention. Other solutions, uses, objectives, and functions within the scope of the invention as claimed below described patent claims should be apparent for the person skilled in the art. It should be appreciated that the steps which are comprised in dashed lines in Fig. 5 are examples of a number of optional steps which may form part of a number of alternative embodiments. The optional steps need not be performed in order. Furthermore, it should be appreciated that not all of the optional steps need to be performed.

The method 200 comprises obtaining S202, by a vehicle of the fleet of vehicles, sensor data depicting a surrounding environment of the vehicle and captured by one or more sensors of the vehicle. In some embodiments, obtaining S202 the sensor data comprises collecting the sensor data from a received sensor data stream that is output from the one or more sensors of the vehicle. In another example, the sensor data is retrieved from a storage or data buffer in which the sensor data is stored. The data buffer may be of a suitable size or length depending on specific realizations. In more detail, the sensor data buffer may be of any size deemed suitable, e.g. in consideration of data capacity restraints and/or characteristics of the sensor data samples, and may for instance range from under a second up to several minutes, or more preferred, from a few seconds up to less than a minute. For example, the data buffer may be configured to store 5 to 20 seconds of the sensor data stream (that is sampled with a set sample rate such as e.g., 10 Hz, 20 Hz, 30 Hz, 40 Hz, etc.), in a First-In First-Out (FIFO) arrangement. However, in some embodiments the data buffer may be configured to store between 30 seconds and 60 seconds of the sensor data stream. This may provide the advantage of being able to capture an entire scenario's development over time.

The method 200 further comprises generating S204, by the vehicle, one or more sensor data embeddings of the sensor data. Moreover, the one or more sensor data embeddings are representations of the sensor data in a multi-dimensional space and generated by processing the sensor data through one or more encoding networks that have been trained to process sensor data and to output a corresponding sensor data embedding for the sensor data in the multi-dimensional space. For further aspects relating to the one or more encoding networks, reference is made to above, in connection with Fig. 1.

Optionally, the method 200 further comprises storing the sensor data embeddings in a data buffer. The data buffer may be of any suitable size as discussed in the foregoing with respect to the sensor data samples. In particular, the sensor data sample buffer and the sensor data embeddings buffer may be of the same size. Thereby, at any given time, the sensor data embeddings representing the sensor data samples collected during the last time period (e.g., the last 10s, 20s, or 30s) are readily available.

The method 200 further comprises transmitting S206, by the vehicle, the one or more sensor data embeddings to the server. Optionally, the method 200 further comprises transmitting S208 a subset of the obtained sensor data to the server.

Moving on to the server-end. The method 200 comprises receiving S210, by the server, the one or more sensor data embeddings from the vehicle (corresponding to step S102 in Fig. 1).

Optionally, the method 200 further comprises receiving S212 the subset of the sensor data from the vehicle (corresponding to step S104 in Fig. 1).

The method 200 further comprises generating S214, by the server, synthetic data from the one or more sensor data embeddings (corresponding to step S106 in Fig. 1). The synthetic data being associated with the sensor data represented by the one or more sensor data embeddings and generated by processing the sensor data embeddings through one or more decoding networks that has been trained to process sensor data embeddings and to output corresponding synthetic data for each sensor data embedding. Each of the one or more decoding networks having been trained in association with at least one of the one or more encoding networks so as to relate to the same multi-dimensional space.

The method 200 further comprises storing S216, by the server, the generated synthetic data (corresponding to step S108 in Fig. 1).

Certain steps of the vehicle-side method may be performed in response to certain triggering events being fulfilled. The triggering events may be detected based on a monitoring of external parameters of the surrounding environment or internal parameters of the vehicle. For example, the triggering event may be detected in the vehicle as the activation of a certain system in the vehicle, such as an emergency brake system, or a collision avoidance system. In another example, the triggering event may be detected in the vehicle based on a motion of the vehicle (e.g. certain steering maneuvers, motion of the vehicle in the lateral and/or longitudinal direction, etc.). In some embodiments, the triggering events may be set based on request (e.g. a query) sent from the server. As an example, the server may request sensor data depicting certain surrounding environments or scenarios. This may e.g. be performed by transmitting a query embedding to the vehicle. The vehicle may in turn generate sensor data embeddings continuously, as the vehicle is driven around. As new sensor data embeddings are generated, they may be compared against the query embedding. Transmitting S206 the one or more sensor data embeddings to the server may then be performed in response to the one or more sensor data embeddings matching the query embedding. In some embodiments, the generation of sensor data embeddings may be triggered by a certain event (in the vehicle or experienced by the vehicle), rather than being run continuously. In such case, the generated sensor data embeddings may be transmitted to the server directly, as opposed to first being compared to a query embedding.

More specifically, the method 200 may further comprise receiving a query embedding (i.e. a request), where the query embedding has been generated by processing a query (e.g. a text, image, or video query) through one or more query embedding networks that have been trained to process queries and to output a corresponding query embedding for each query in the multi-dimensional space. The query embedding may e.g. be generated by the server. Moreover, each of the one or more query embedding networks have been trained in association with one or more of the encoding networks such that a query embedding of a query that is contextually related to a specific sensor data sample points towards the same point as the sensor data embedding of that sensor data sample within the multi-dimensional space. In some embodiments, multiple query embeddings networks may be provided, e.g., one for every input type such as e.g., free-text input, image input or video input. However, in some embodiments a single, larger, query embedding network may be employed capable of handling queries of different input formats, where the different types of queries may be ingested separately or in combined fashion.

The method 200 may further comprise comparing the one or more generated sensor data embeddings with the received query embedding. The one or more sensor data embeddings may be compared to the query embedding based on a proximity to the received query embedding within the multi-dimensional space. In some embodiments comparing the one or more sensor data embeddings to the query embedding comprises determining whether the one or more sensor data embeddings are within a distance value (distance threshold) from the query embedding within the multi-dimensional space. Thus, the sensor data embeddings may be compared to the received query embedding in view of a distance metric in order to identify the relevant sensor data embeddings.

The step of transmitting S206 the one or more sensor data embeddings may then be performed in response to the one or more sensor data embeddings being with the distance value from the query embedding.

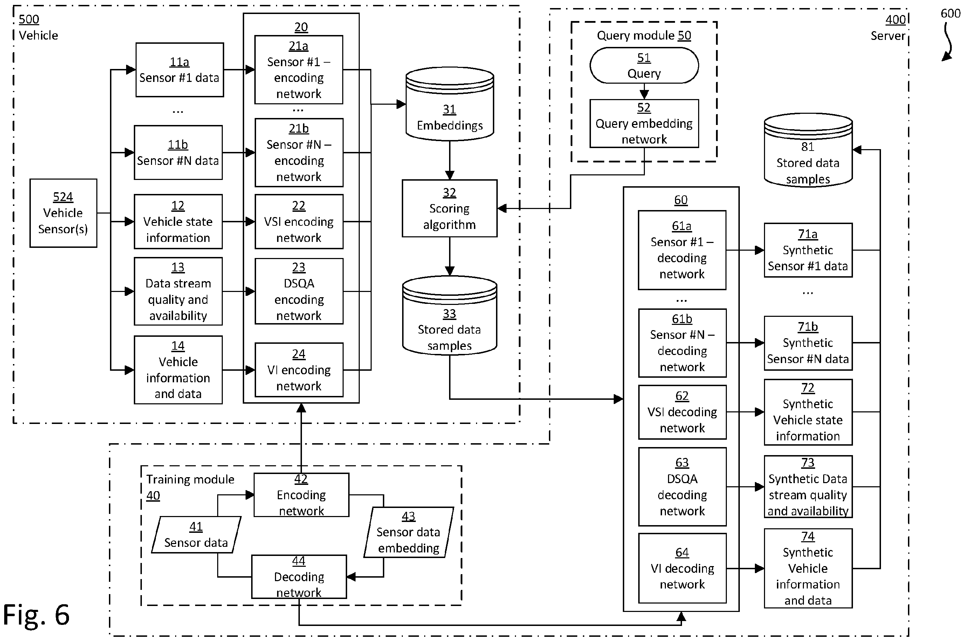

The distance value (distance threshold) may be predefined. In some embodiments the distance value (distance threshold) is dynamically set. For example, the distance value (distance threshold) may be dynamically set by the query directly or indirectly (e.g., metadata associated with the query). In more detail, the query may include some operators or commands that define distance value (threshold) such as e.g., "small" (or "narrow"), "medium", "large" ("or "broad"). Alternatively, the operators or commands may be set in the metadata of the query through which the query is generated. The comparison may then account for the operators or commands when searching for matching sensor data embeddings. Moreover, the term "within a distance value" may be construed as "fulfilling a distance metric", where the distance metric may be that the embeddings fulfilling the metric are the embeddings that are within a Euclidian/Manhattan/Cosine distance value (e.g., distance threshold) from the query embedding. Further aspects relating to the triggering events will be explained below in connection with Fig. 6.

Executable instructions for performing these functions are, optionally, included in a non-transitory computer-readable storage medium or other computer program product configured for execution by one or more processors.

Figure 3 illustrates, by way of example, a system 300 according to some embodiments. More specifically, a system 300 being configured to implement the principles of the presently disclosed technology. The system 300 should therefore be seen as a non-limiting example of a realization of the herein disclosed aspects of the present technology. For instance, the system 300 may be configured to perform the method 200 described above in connection with Fig. 2. Thus, any features or principles described above in connection with Fig. 2 are applicable also to the system 300 as described herein, and vice versa, unless otherwise stated.

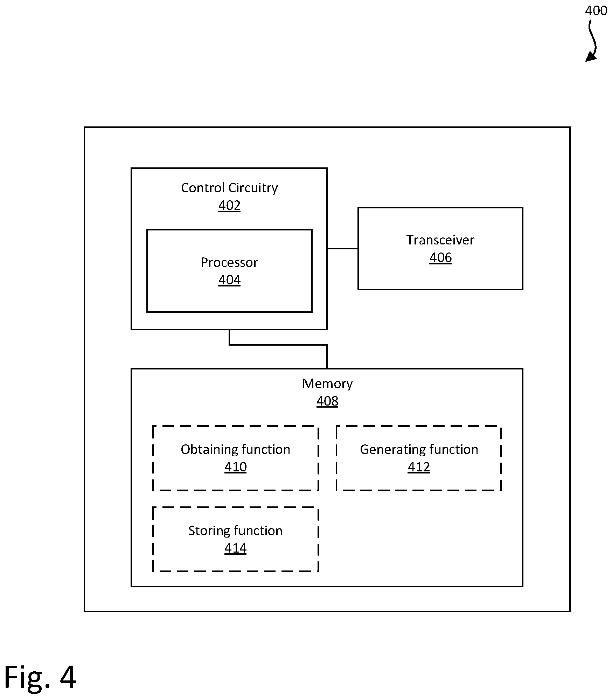

The system 300 comprises a server 302 (or remote, cloud, central, back-office, fleet, or back-end server), referred to in the following as the remote server 302 or just server 302. The server 302 may be configured to perform the method 100 as described above in connection to Fig. 1 (as well as the server-end method 200b as described above in connection with Fig. 2). Thus, any features described in connection with Fig. 1 and/or Fig. 2 are applicable also to the server 302. As illustrated, the server 302 may be provided in the cloud, i.e. as a cloud-implemented server. Advantageously, the server 302 may perform more computational heavy tasks, or manage and coordinate the fleet of vehicles (further described below), such as aggregating data from, or distributing data to, the different vehicles of the fleet, or updating ADS functions and distributing the updates to the fleet. A schematic illustration of the server 302, by way of example, will be presented below in connection with Fig. 4.

The system 300 further comprises one or more vehicles 304a-c, also referred to as a fleet of vehicles 304a-c. The one or more vehicles 304a-c may be vehicles as further described below in connection with Fig. 5. Thus, the one or more vehicles 304a-c may be configured to at least perform the vehicle-end method 200a of the method 200 described above in connection with Fig. 2. Thus, any principles and aspects described above in connection with Fig. 2 apply also to the vehicles 304a-c of the fleet of vehicles. The fleet illustrated in Fig. 3 comprises three vehicles, a first, second and third vehicle 304a-c, by way of example. The system 300 may however comprise any number of vehicles 304a-c. In the following, reference will mainly be made to the first vehicle 304a, however the same aspects apply also to the other vehicles of the fleet of vehicles.

The one or more vehicles 304a-c are communicatively connected to the remote server 302. This may provide for transmitting and/or receiving data 306 between the vehicles and the server. The one or more vehicles 304a-c may be further communicatively connected to each other. The data 306 may be any kind of data, such as communication signals, sensor data, sensor data embeddings, etc. The communication may be performed by any suitable wireless communication protocol. The wireless communication protocol may e.g. be long range communication protocols, such as cellular communication technologies (e.g. GSM, GPRS, EDGE, LTE, 5G, 5G NR, etc.) or short to mid-ranged communication protocols, such as Wireless Local Area Network (WLAN) (e.g. IEEE 802.11) based solutions. The sever 302 comprises a suitable memory and control circuitry, for example, one or more processors or processing circuitry, as well as one or more other components such as a data interface and transceiver. The server 302 may also include software modules or other components, such that the control circuity can be configured to execute machine-readable instructions loaded from memory to implement the steps of the method to be performed.

As mentioned above, each vehicle of the one or more vehicles 304a-c may be configured to perform the vehicle-end method 200a, as described above in connection with Fig. 2, while the server 302 may be configured to perform the server-end method 200b. It is however to be appreciated that these examples should not be seen as limiting, as several different ways of implementation may be possible, depending on a specific realization. For further details regarding the different steps, reference is made to Fig. 1 and Fig. 2 above, in order to avoid undue repetition.

Figure 4 is a schematic illustration of a server 400, for collecting data samples for development of an automated driving system of a vehicle. The server 400 may be the server 302 as described above in connection with Fig. 3, and configured to perform the principles described above.

The server 400 as described herein refers to any computer system or general computing device. The server (may also be referred to as remote server, cloud server, central server, back-office server, fleet server, or back-end server, or a networked device configured to provide various computing services, data storage, processing capabilities, or resources to clients or users over a communication network. In the present case, the wording "clients" refers to connected vehicles (such as the vehicles of a fleet of vehicles 304a-c described above). Even though the server 400 is herein illustrated as one device, the server 400 may be a distributed computing system, formed by a number of different computational devices.

The server 400 comprises control circuitry 402. The control circuitry 402 may physically comprise one single circuitry device. Alternatively, the control circuitry 402 may be distributed over several circuitry devices.

As shown in the example of Fig. 4, the server 400 may further comprise a transceiver 406 and a memory 408. The control circuitry 402 being communicatively connected to the transceiver 406 and the memory 408. The control circuitry 402 may comprise a data bus, and the control circuitry 402 may communicate with the transceiver 406 and/or the memory 408 via the data bus.

The control circuitry 402 may be configured to carry out overall control of functions and operations of the server 400. The control circuitry 402 may include a processor 404, such as a central processing unit (CPU), microcontroller, or microprocessor. The processor 404 may be configured to execute program code stored in the memory 408, in order to carry out functions and operations of the server 400. The control circuitry 402 is configured to perform the steps of the method 100 as described above in connection with Fig. 1 (and/or the server-end method 200b described in connection with Fig. 2). The steps may be implemented in one or more functions stored in the memory 408.

The transceiver 406 is configured to enable the server 400 to communicate with other entities, such as vehicles or other servers. The transceiver 406 may both transmit data from and receive data to the server 400.

The memory 408 may be a non-transitory computer-readable storage medium. The memory 408 may be one or more of a buffer, a flash memory, a hard drive, a removable media, a volatile memory, a non-volatile memory, a random access memory (RAM), or another suitable device. In a typical arrangement, the memory 408 may include a non-volatile memory for long-term data storage and a volatile memory that functions as system memory for the server 400. The memory 408 may exchange data with the circuitry 402 over the data bus. Accompanying control lines and an address bus between the memory 408 and the circuitry 402 also may be present.

Functions and operations of the server 400 may be implemented in the form of executable logic routines (e.g., lines of code, software programs, etc.) that are stored on a non-transitory computer readable recording medium (e.g., the memory 408) of the server 400 and are executed by the circuitry 402 (e.g., using the processor 404). Put differently, when it is stated that the circuitry 402 is configured to execute a specific function, the processor 204 of the circuitry 402 may be configured execute program code portions stored on the memory 408, wherein the stored program code portions correspond to the specific function. Furthermore, the functions and operations of the circuitry 402 may be a stand-alone software application or form a part of a software application that carries out additional tasks related to the circuitry 402. The described functions and operations may be considered a method that the corresponding device is configured to carry out, such as the method 100 discussed above in connection with Fig. 1. In addition, while the described functions and operations may be implemented in software, such functionality may as well be carried out via dedicated hardware or firmware, or some combination of one or more of hardware, firmware, and software. In the following, the function and operations of the server 400 is described.

The control circuitry 402 is configured to obtain one or more sensor data embeddings of sensor data depicting a surrounding environment of the vehicle. This may e.g. be performed by execution of an obtaining function 410. The one or more sensor data embeddings are representations of the sensor data in a multi-dimensional space and generated by processing the sensor data through one or more encoding networks that have been trained to process sensor data and to output a corresponding sensor data embedding for the sensor data in the multi-dimensional space.

The control circuitry 402 is further configured to generate synthetic data from the one or more sensor data embeddings. This may e.g. be performed by a generating function 412. The synthetic data is associated with the sensor data represented by the one or more sensor data embeddings and generated by processing the sensor data embeddings through one or more decoding networks that has been trained to process sensor data embeddings and to output corresponding synthetic data for each sensor data embedding. Each of the one or more decoding networks has been trained in association with at least one of the one or more encoding networks so as to relate to the same multi-dimensional space.

The control circuitry 402 is further configured to store the generated synthetic data. This may e.g. be performed by execution of a storing function 414.

It should be noted that the principles, features, aspects, and advantages of the method 100 and 200 as described above in connection with Fig. 1 and 2, are applicable also to the server 400 as described herein. In order to avoid undue repetition, reference is made to the above.

Figure 5 is a schematic illustration of a vehicle 500 in accordance with some embodiments. The vehicle 500 is equipped with an Automated Driving System (ADS) 510. As used herein, a "vehicle" is any form of motorized transport. For example, the vehicle 500 may be any road vehicle such as a car (as illustrated herein), a motorcycle, a (cargo) truck, a bus, a smart bicycle, etc.

The vehicle 500 may be configured to at least perform the steps of the vehicle-side method 200a of the method 200 as described above in connection with Fig. 2. This may e.g. be performed by control circuitry 504 of the vehicle (further described below).

The vehicle 500 comprises a number of elements which can be commonly found in autonomous or semi-autonomous vehicles. It will be understood that the vehicle 500 can have any combination of the various elements shown in Fig. 5. Moreover, the vehicle 500 may comprise further elements than those shown in Fig. 5. While the various elements are herein shown as located inside the vehicle 500, one or more of the elements can be located externally to the vehicle 500. Further, even though the various elements are herein depicted in a certain arrangement, the various elements may also be implemented in different arrangements, as readily understood by the skilled person. It should be further noted that the various elements may be communicatively connected to each other in any suitable way. The vehicle 500 of Fig. 5 should be seen merely as an illustrative example, as the elements of the vehicle 500 can be realized in several different ways.

The vehicle 500 comprises a control system 502. The control system 502 is configured to carry out overall control of functions and operations of the vehicle 500. The control system 502 comprises control circuitry 504 and a memory 506. The control circuitry 502 may physically comprise one single circuitry device. Alternatively, the control circuitry 502 may be distributed over several circuitry devices. As an example, the control system 502 may share its control circuitry 504 with other parts of the vehicle. The control circuitry 502 may comprise one or more processors, such as a central processing unit (CPU), microcontroller, or microprocessor. The one or more processors may be configured to execute program code stored in the memory 506, in order to carry out functions and operations of the vehicle 500. The processor(s) may be or include any number of hardware components for conducting data or signal processing or for executing computer code stored in the memory 506. In some embodiments, the control circuitry 504, or some functions thereof, may be implemented on one or more so-called system-on-a-chips (SoC). As an example, the ADS 510 may be implemented on a SoC. The memory 506 optionally includes high-speed random-access memory, such as DRAM, SRAM, DDR RAM, or other random-access solid-state memory devices; and optionally includes non-volatile memory, such as one or more magnetic disk storage devices, optical disk storage devices, flash memory devices, or other non-volatile solid-state storage devices. The memory 506 may include database components, object code components, script components, or any other type of information structure for supporting the various activities of the present description.

In the illustrated example, the memory 506 further stores map data 508. The map data 508 may for instance be used by the ADS 510 of the vehicle 500 in order to perform autonomous functions of the vehicle 500. The map data 508 may comprise high-definition (HD) map data. It is contemplated that the memory 508, even though illustrated as a separate element from the ADS 510, may be provided as an integral element of the ADS 510. In other words, according to some embodiments, any distributed or local memory device may be utilized in the realization of the present inventive concept. Similarly, the control circuitry 504 may be distributed e.g. such that one or more processors of the control circuitry 504 is provided as integral elements of the ADS 510 or any other system of the vehicle 500. In other words, according to an exemplary embodiment, any distributed or local control circuitry device may be utilized in the realization of the present inventive concept.

The vehicle 500 further comprises a sensor system 520. The sensor system 520 is configured to acquire sensory data about the vehicle itself, or of its surroundings. The sensor system 520 may for example comprise a Global Navigation Satellite System (GNSS) module 522 (such as a GPS) configured to collect geographical position data of the vehicle 500. The sensor system 520 may further comprise one or more sensors 524. The one or more sensor(s) 524 may be any type of on-board sensors, such as cameras, LIDARs and RADARs, ultrasonic sensors, gyroscopes, accelerometers, odometers etc. It should be appreciated that the sensor system 520 may also provide the possibility to acquire sensory data directly or via dedicated sensor control circuitry in the vehicle 500.

The vehicle 500 further comprises a communication system 526. The communication system 526 is configured to communicate with external units, such as other vehicles (i.e. via vehicle-to-vehicle (V2V) communication protocols), remote servers (e.g. cloud servers, as shown above in connection with Fig. 4), databases or other external devices, i.e. vehicle-to-infrastructure (V2I) or vehicle-to-everything (V2X) communication protocols. The communication system 526 may communicate using one or more communication technologies. The communication system 526 may comprise one or more antennas. Cellular communication technologies may be used for long-range communication such as to remote servers or cloud computing systems. In addition, if the cellular communication technology used have low latency, it may also be used for V2V, V2I or V2X communication. Examples of cellular radio technologies are GSM, GPRS, EDGE, LTE, 5G, 5G NR, and so on, also including future cellular solutions. However, in some solutions mid to short-range communication technologies may be used such as Wireless Local Area (LAN), e.g. IEEE 802.11 based solutions, for communicating with other vehicles in the vicinity of the vehicle 500 or with local infrastructure elements. ETSI is working on cellular standards for vehicle communication and for instance 5G is considered as a suitable solution due to the low latency and efficient handling of high bandwidths and communication channels.

The communication system 526 may further provide the possibility to send output to a remote location (e.g. remote operator or control center) by means of the one or more antennas. Moreover, the communication system 526 may be further configured to allow the various elements of the vehicle 500 to communicate with each other. As an example, the communication system may provide a local network setup, such as CAN bus, I2C, Ethernet, optical fibers, and so on. Local communication within the vehicle may also be of a wireless type with protocols such as WiFi, LoRa, Zigbee, Bluetooth, or similar mid/short range technologies.

The vehicle 500 further comprises a maneuvering system 520. The maneuvering system 528 is configured to control the maneuvering of the vehicle 500. The maneuvering system 528 comprises a steering module 530 configured to control the heading of the vehicle 500. The maneuvering system 528 further comprises a throttle module 532 configured to control actuation of the throttle of the vehicle 500. The maneuvering system 528 further comprises a braking module 534 configured to control actuation of the brakes of the vehicle 500. The various modules of the steering system 528 may receive manual input from a driver of the vehicle 500 (i.e. from a steering wheel, a gas pedal and a brake pedal respectively). However, the maneuvering system 528 may be communicatively connected to the ADS 510 of the vehicle, to receive instructions on how the various modules should act. Thus, the ADS 510 can control the maneuvering of the vehicle 500.

As stated above, the vehicle 500 comprises an ADS 510. The ADS 510 may be part of the control system 502 of the vehicle. The ADS 510 is configured to carry out the functions and operations of the autonomous functions of the vehicle 500. The ADS 510 can comprise a number of modules, where each module is tasked with different functions of the ADS 510.

The ADS 510 may comprise a localization module 512 or localization block/system. The localization module 512 is configured to determine and/or monitor a geographical position and heading of the vehicle 500, and may utilize data from the sensor system 520, such as data from the GNSS module 522. Alternatively, or in combination, the localization module 512 may utilize data from the one or more sensors 524. The localization system may alternatively be realized as a Real Time Kinematics (RTK) GPS in order to improve accuracy.

The ADS 510 may further comprise a perception module 514 or perception block/system. The perception module 514 may refer to any commonly known module and/or functionality, e.g. comprised in one or more electronic control modules and/or nodes of the vehicle 500, adapted and/or configured to interpret sensory data - relevant for driving of the vehicle 500 - to identify e.g. obstacles, vehicle lanes, relevant signage, appropriate navigation paths etc. The perception module 514 may thus be adapted to rely on and obtain inputs from multiple data sources, such as automotive imaging, image processing, computer vision, and/or in-car networking, etc., in combination with sensory data e.g. from the sensor system 520.

An object detection model for detecting and/or classifying object in the surrounding environment of the vehicle 500 (or other types of machine learning models) may be part of the ADS 510, or more specifically part of the perception module 514. Such models may be a local copy of a global model managed by a remote (of fleet) server, i.e. as part of a federated learning scheme.

The localization module 512 and/or the perception module 514 may be communicatively connected to the sensor system 520 in order to receive sensor data from the sensor system 520. The localization module 512 and/or the perception module 514 may further transmit control instructions to the sensor system 520.

The ADS may further comprise a path planning module 516. The path planning module 516 is configured to determine a planned path of the vehicle 500 based on a perception and location of the vehicle as determined by the perception module 514 and the localization module 512 respectively. A planned path determined by the path planning module 516 may be sent to the maneuvering system 528 for execution.

The ADS may further comprise a decision and control module 518. The decision and control module 518 is configured to perform the control and make decisions of the ADS 510. For example, the decision and control module 518 may decide on whether the planned path determined by the path-planning module 516 should be executed or not.

It should be understood that parts of the described solution may be implemented either in the vehicle 500, in a system located external to the vehicle, or in a combination of internal and external to the vehicle; for instance in a server in communication with the vehicle, a so called cloud solution, as is further explained above in connection with Fig. 4. The different features and steps of the embodiments may be combined in other combinations than those described. Further, the elements of the vehicle 500 (i.e. the systems and modules) may be implemented in different combinations than those described herein.

Fig. 6 is a schematic block diagram representation illustrating, by way of example, a system 600 in accordance with some embodiments. The system 600 comprises control circuitry configured to perform the functions of the method 200 disclosed herein. Moreover, the system 600 illustrated herein can be seen as an alternative representation of the system 300 described above in connection with Fig. 3. Thus, any aspects or principles of the system 300 apply also to the system 600 of Fig. 6, and vice versa. In order to better elucidate the herein disclosed embodiments, the system is represented as various "modules" or blocks in Fig. 6, each of them linked to one or more specific functions of the systems.

When stated e.g. "vehicle is configured to ...", or "server configured to ...", it is herein meant that control circuitry of the vehicle/server is configured to perform the described function.

In more detail, Fig. 6 depicts the data flow within the system 600 for managing event recordings/collecting data samples for ADS development. In the depicted embodiment, the system 10 depicts a run-time solution, where the processes discussed in the foregoing are executed while the vehicle 500 and server 400 are operating. However, as readily understood by the skilled artisan, the same principles are applicable in an offline solution with some minor modifications (e.g., replacing the direct sensor data input with data repositories storing larger datasets).

One or more sensors 524 of the vehicle 500 provides sensor data 11a-14 of one or more sensor data types, or any other associated data. As illustrated herein, the vehicle sensors(s) 524 may provide sensor data of 1 to N different sensor data types, including e.g. image data from one or more cameras, lidar data, radar data, ultrasonic data, etc. Other forms of data (commonly referred to as meta data) may include vehicle state information 12, data stream quality and availability, and vehicle information and data. Even through the sensor data samples 11a-14 are illustrated as being provided directly from the vehicle sensor(s) 524, the sensor data may be temporarily stored or "buffered" in a suitable data buffer.

The sensor data is then fed to one or more encoding networks 20. Herein, the one or more encoding networks comprises one encoding network 21a-24 per sensor data type. Sensor data embeddings can then be generated by processing each sensor data sample 11a, 11b, through a corresponding encoding network 21a, 21b that have been trained to process sensor data and to output a corresponding sensor data embedding for each sensor data sample in a multi-dimensional space. Just as for the sensor data samples, the sensor data embeddings may be stored in a corresponding data buffer 31.

The system 600 may comprise multiple encoding networks 21a, 21b, one for each specific sensor type 11a, 11b. For example, the system may comprise one encoding network for a first camera of the vehicle, one encoding network for a second camera of the vehicle, one encoding network for a lidar of the vehicle, and so forth. Furthermore, the system 10 may comprise additional encoding networks 22, 23, 24 for other data types, such as e.g., vehicle state information ("VSI") 12, data stream quality and availability 13, and vehicle information and data 14. In more detail, the vehicle state information may include a position, heading, and/or speed of the vehicle, the data stream quality and availability may comprise quality and availability parameters of the output from the sensors 524. The vehicle information and data may comprise vehicle model, ADS software version, and so forth. However, in some embodiments, the other data types 12-14 may in some embodiments be included as metadata in the sensor data samples and therefore be incorporated in the sensor data embeddings.

After being generated, the sensor data embeddings may be transmitted to the server for further processing. However, as described above, the transmission of the sensor data embeddings may be conditioned upon a triggering event. In the present example, the triggering event is based on a comparison between the one or more sensor data embeddings, and a query embedding. The vehicle is therefore configured to receive a query embedding (e.g., from the server 400). Here, the query embedding has been generated by processing a query 51 (e.g. a free-text query, an image query, or a video query) through one or more query embedding networks 52 that have been trained to process queries 51 and to output a corresponding query embedding for each query in the multi-dimensional space. Moreover, each of the one or more query embedding networks 52 have been trained in association with one or more of the encoding networks 21a, 21b such that a query embedding of a query 51 that is contextually related to a specific sensor data sample points towards the same point as the sensor data embedding of that sensor data sample within the multi-dimensional space. The one or more query embedding is herein performed by a query module 50 provided in the server 400. However, in some embodiments, the vehicle 500 is configured to receive a user query 51, and to generate the query embedding by processing the query through one or more query embedding networks that have been trained to process queries and to output a corresponding query embedding for each query in the multi-dimensional space. In other words, the query embedding network 90 may be part of the vehicle 500 rather than the remote server 400 in some embodiments.

Accordingly, some embodiments herein propose an architecture where one encoding network serves as a basis for training the query embedding network(s). In more detail, once an encoding network has been trained to generate sensor data embeddings, one can train a query embedding network against the encoding network so that the generated query embeddings that are associated with a particular sensor data sample points towards the same point as the corresponding sensor data embedding of that particular sensor data sample in the multi-dimensional space. This can for example be done by creating training examples with training pairs of queries and corresponding sensor data samples as known in the art of machine learning. For example, a training pair could be the query "stop signs" and then sensor data samples (e.g., camera images) of stop signs are retrieved and their corresponding embeddings are used to form a ground truth for the query embedding network. Thereby one attains a connection between queries and the sensor data samples, and searching for specific sensor data samples with e.g., free text queries is enabled.

Further, the vehicle 500 is configured to compare the one or more sensor data embeddings with the query embeddings, in line with the principles described in the foregoing. This is herein represented by the scoring algorithm block 32, where the matching/scoring algorithm is configured to score embeddings based on their relevancy as defined by the distance values from the query embedding. Some suitable distance metrics that may be used are Euclidian Distance, Manhattan Distance, or Cosine distance.

Further, the vehicle 500 may be configured to store the sensor data embeddings fulfilling the scoring algorithm 32 as data samples in a persistent data storage 33 or a data storage unit 33.

In another example, the vehicle may transmit sensor data embeddings representative of sensor data depicting a certain scenario of interest as determined locally in the vehicle.

The one or more sensor data embeddings obtained by the server 400 can be fed to one or more decoding networks 60. As with the encoding networks 20, one decoding network 61a-64 may be provided for each sensor data type. Each decoding network being trained to generate synthetic (sensor) data based on sensor data embeddings fed to the networks. Thus, depending on what synthetic data 71a-74 is to be generated, the one or more sensor data embeddings received from the vehicle may be fed to a certain decoding network.

The generated synthetic data may subsequently be stored, e.g. in a storage medium 81 or database 81 for subsequent use in development of an ADS (or any function thereof). For example, the synthetic data may be used for data analysis, simulation, regression testing, training of machine learning models, etc. Optionally, also the one or more sensor data embeddings may be stored in the server. Storing the sensor data embeddings can be done in a space-efficient way, as well as for improving data management. The stored sensor data embeddings may later be used in generating even better synthetic data, e.g. after the one or more decoding networks improve.

As is further shown in Fig. 6, the system 600 may further comprise a training module 40. The training module may be provided in the server 400, as illustrated herein, or in any other suitable device. The training module 40 may be configured to train (or provide updated) encoding network(s) 42 and decoding network(s) 44 together in a loop such that the encoding network 42 learns to generate sensor data embeddings 43 based on sensor data 41, and the decoding network 44 learns to generate synthetic (sensor) data based on the sensor data embeddings 43. The trained encoding network 42 may then be provided to the one or more encoding networks 20 of the vehicle, and the trained decoding network 44 to the one or more decoding networks 60 of the server.

More specifically, the training process can be described as follows. During training of an encoding network (i.e. embeddings generator), an output embedding is used as input to a decoding network (i.e. synthetic data generator) which generates synthetic (sensor) data as output, using network fusion methodology. Put differently, the encoding network is trained on data A, generating embedding B. Embedding B is used as input to the decoding network generating synthetic data A*, which is compared to A. The complete cycle is used for tuning the weights in both the encoding and decoding network.

It is to be appreciated that a decoding network can be trained according to what is described above. However, it may also (alternatively or in combination) be trained in association with another, already trained, decoding network.

The present invention has been presented above with reference to specific embodiments. However, other embodiments than the above described are possible and within the scope of the invention. Different method steps than those described above, performing the methods by hardware or software, may be provided within the scope of the invention. Thus, according to an exemplary embodiment, there is provided a non-transitory computer-readable storage medium storing one or more programs configured to be executed by one or more processors of a vehicle control system, the one or more programs comprising instructions for performing the methods according to any one of the above-discussed embodiments. Alternatively, according to another exemplary embodiment a cloud computing system can be configured to perform any of the methods presented herein. The cloud computing system may comprise distributed cloud computing resources that jointly perform the methods presented herein under control of one or more computer program products.

Generally speaking, a computer-accessible medium may include any tangible or non-transitory storage media or memory media such as electronic, magnetic, or optical media-e.g., disk or CD/DVD-ROM coupled to computer system via bus. The terms "tangible" and "non-transitory," as used herein, are intended to describe a computer-readable storage medium (or "memory") excluding propagating electromagnetic signals, but are not intended to otherwise limit the type of physical computer-readable storage device that is encompassed by the phrase computer-readable medium or memory. For instance, the terms "non-transitory computer-readable medium" or "tangible memory" are intended to encompass types of storage devices that do not necessarily store information permanently, including for example, random access memory (RAM). Program instructions and data stored on a tangible computer-accessible storage medium in non-transitory form may further be transmitted by transmission media or signals such as electrical, electromagnetic, or digital signals, which may be conveyed via a communication medium such as a network and/or a wireless link.

It should be noted that any reference signs do not limit the scope of the claims, that the invention may be at least in part implemented by means of both hardware and software, and that the same item of hardware may represent several "means" or "units".

## Claims

1. A computer-implemented method (100) for collecting data samples for development of an automated driving system of a vehicle, the method (100) comprising:
obtaining (S102) one or more sensor data embeddings of sensor data depicting a surrounding environment of the vehicle, wherein the one or more sensor data embeddings are representations of the sensor data in a multi-dimensional space and generated by processing the sensor data through one or more encoding networks that have been trained to process sensor data and to output a corresponding sensor data embedding for the sensor data in the multi-dimensional space;
generating (S106) synthetic data from the one or more sensor data embeddings, wherein the synthetic data is associated with the sensor data represented by the one or more sensor data embeddings and generated by processing the sensor data embeddings through one or more decoding networks that has been trained to process sensor data embeddings and to output corresponding synthetic data for each sensor data embedding, and wherein each of the one or more decoding networks has been trained in association with at least one of the one or more encoding networks so as to relate to the same multi-dimensional space; and
storing (S108) the generated synthetic data.

2. The method (100) according to claim 1, wherein the sensor data represented by the one or more sensor data embeddings comprises data of one or more sensor data types.

3. The method (100) according to claim 2, wherein each sensor data embedding of the one or more sensor data embeddings corresponds to a respective sensor data type of the one or more sensor data types.

4. The method (100) according to claim 2 or 3, wherein the one or more encoding networks comprise a plurality of encoding networks of which each encoding network represent a respective sensor data type of the one or more senor data types,
wherein the plurality of encoding networks comprises a first encoding network trained to process sensor data of a first sensor data type and to output a corresponding sensor data embedding, and a second encoding network trained to process a second sensor data type and to output a corresponding sensor data embedding,
wherein the first encoding network has been trained in association with the second encoding network such that a sensor data embedding generated by the first encoding network and a sensor data embedding generated by the second encoding network point towards the same point within the multi-dimensional space when the sensor data embeddings are contextually, spatially and/or temporally related.

5. The method (100) according to any one of the claims 2 to 4, wherein the one or more encoding networks comprise a fused encoding network trained to process fused sensor data, wherein the fused sensor data comprises a fusion of at least two sensor data types of the one or more sensor data types.

6. The method (100) according to any one of the claims 2 to 5, wherein the synthetic data comprises synthetic sensor data, the synthetic sensor data comprising synthetic sensor data of at least one sensor data type in common with the one or more sensor data types of the sensor data represented by the obtained one or more sensor data embeddings.

7. The method (100) according to any one of the claims 2 to 6, wherein the synthetic data comprises synthetic sensor data, the synthetic sensor data comprising synthetic sensor data of at least one sensor data type other than the one or more sensor data types of the sensor data represented by the obtained one or more sensor data embeddings.

8. The method (100) according to any one of the claims 2 to 7, wherein the sensor data represented by the one or more sensor data embeddings depicts the surrounding environment of the vehicle at a first point in time, and
wherein the synthetic data pertains to the surrounding environment of the vehicle at a second point in time.

9. The method (100) according to any one of the claims 1 to 8, wherein the synthetic data comprises a textual description of the sensor data represented by the obtained one or more sensor data embeddings.

10. The method (100) according to any one of the claims 1 to 9, further comprising:
obtaining (S104) a subset of the sensor data represented by the one or more sensor data embeddings, and
wherein generating (S106) the synthetic sensor data is further based on the obtained subset of the sensor data.

11. The method (100) according to claim 10, when dependent on claim 2, wherein the obtained subset of the sensor data represented by the one or more sensor data embedding comprises data of at least one sensor data type of the one or more sensor data types.

12. A computer program product comprising instructions which, when the program is executed by a computing device, causes the computing device to carry out the method (100) according to any one of claims 1-11.

13. A server (400) for collecting data samples for development of an automated driving system of a vehicle, the server (400) comprising control circuitry (402) configured to:
obtain one or more sensor data embeddings of sensor data depicting a surrounding environment of the vehicle, wherein the one or more sensor data embeddings are representations of the sensor data in a multi-dimensional space and generated by processing the sensor data through one or more encoding networks that have been trained to process sensor data and to output a corresponding sensor data embedding for the sensor data in the multi-dimensional space;
generate synthetic data from the one or more sensor data embeddings, wherein the synthetic data is associated with the sensor data represented by the one or more sensor data embeddings and generated by processing the sensor data embeddings through one or more decoding networks that has been trained to process sensor data embeddings and to output corresponding synthetic data for each sensor data embedding, and wherein each of the one or more decoding networks has been trained in association with at least one of the one or more encoding networks so as to relate to the same multi-dimensional space; and
store the generated synthetic data.

14. A method (200) for managing event recordings in a system comprising a fleet of vehicles equipped with an automated driving system, and a server communicatively connected to the fleet of vehicles, the method (200) comprising:
obtaining (S202), by a vehicle of the fleet of vehicles, sensor data depicting a surrounding environment of the vehicle and captured by one or more sensors of the vehicle;
generating (S204), by the vehicle, one or more sensor data embeddings of the sensor data, wherein the one or more sensor data embeddings are representations of the sensor data in a multi-dimensional space and generated by processing the sensor data through one or more encoding networks that have been trained to process sensor data and to output a corresponding sensor data embedding for the sensor data in the multi-dimensional space;
transmitting (S206), by the vehicle, the one or more sensor data embeddings to the server;
receiving (S210), by the server, the one or more sensor data embeddings from the vehicle;
generating (S214), by the server, synthetic data from the one or more sensor data embeddings, wherein the synthetic data is associated with the sensor data represented by the one or more sensor data embeddings and generated by processing the sensor data embeddings through one or more decoding networks that has been trained to process sensor data embeddings and to output corresponding synthetic data for each sensor data embedding, and wherein each of the one or more decoding networks has been trained in association with at least one of the one or more encoding networks so as to relate to the same multi-dimensional space; and
storing (S216), by the server, the generated synthetic data.

15. A system (300) comprising:
a fleet of vehicles (304a-c) equipped with an automated driving system, and
a server (302) communicatively connected to the fleet of vehicles (304a-c),
wherein a vehicle (304a) of the fleet of vehicles comprises control circuitry configured to:
obtain sensor data depicting a surrounding environment of the vehicle and captured by one or more sensors of the vehicle;
generate one or more sensor data embeddings of the sensor data, wherein the one or more sensor data embeddings are representations of the sensor data in a multi-dimensional space and generated by processing the sensor data through one or more encoding networks that have been trained to process sensor data and to output a corresponding sensor data embedding for the sensor data in the multi-dimensional space; and
transmit the one or more sensor data embeddings to the server;
wherein the server (302) comprises control circuitry configured to:
receive the one or more sensor data embeddings from the vehicle;
generate synthetic data from the one or more sensor data embeddings, wherein the synthetic data is associated with the sensor data represented by the one or more sensor data embeddings and generated by processing the sensor data embeddings through one or more decoding networks that has been trained to process sensor data embeddings and to output corresponding synthetic data for each sensor data embedding, and wherein each of the one or more decoding networks has been trained in association with at least one of the one or more encoding networks so as to relate to the same multi-dimensional space; and
store the generated synthetic data.
